# EUROPÄISCHE PATENTSCHRIFT

(11) **EP 3 259 796 B1**
(45) Veröffentlichungstag und Bekanntmachung des Hinweises auf die Patenterteilung: **09.09.2020**
(21) Anmeldenummer: 16704025.2
(22) Anmeldetag: 12.02.2016
(51) Int. Cl.: H01M 10/42, H01M 10/48, G01R 31/36

(54) **BATTERIEZELLE FÜR EINE BATTERIE EINES KRAFTFAHRZEUGS, BATTERIE SOWIE KRAFTFAHRZEUG**
BATTERY CELL FOR A BATTERY OF A MOTOR VEHICLE, BATTERY, AND MOTOR VEHICLE
ÉLÉMENT DE BATTERIE POUR BATTERIE D'UN VÉHICULE AUTOMOBILE, BATTERIE ET VÉHICULE AUTOMOBILE

(30) Priorität: 18.02.2015 DE 102015002076
(43) Veröffentlichungstag der Anmeldung: 27.12.2017
(73) Patentinhaber: Audi AG, 85045 Ingolstadt (DE)
(72) Erfinder: HINTERBERGER, Michael, 85055 Ingolstadt (DE); HELLENTHAL, Berthold, 90596 Schwanstetten (DE)
(74) Vertreter: Neuhausen, Marc-Alexander
(86) Internationale Anmeldenummer: PCT/EP2016/053072
(87) Internationale Veröffentlichungsnummer: WO 2016/131731

(56) Entgegenhaltungen:
- WO-A1-2012/034045
- WO-A1-2012/062574
- WO-A1-2013/143755
- DE-A1-102011 016 373
- DE-A1-102012 203 444
- US-A1- 2014 184 165

## Beschreibung

Die Erfindung betrifft eine Batteriezelle für eine Batterie eines Kraftfahrzeugs mit einem galvanischen Element, einem Batteriezellengehäuse zum Aufnehmen des galvanischen Elementes und zumindest zwei mikroelektronischen Schaltungen zum Überwachen der Batteriezelle. Die Erfindung betrifft außerdem eine Batterie sowie ein Kraftfahrzeug.

Bei an sich bekannten Batteriezellen ist üblicherweise jeweils ein galvanisches Element in einem Batteriezellengehäuse angeordnet. Zum Bereitstellen einer bestimmten Spannung beziehungsweise eines bestimmen Stromes können mehrere Batteriezellen zu einer Batterie zusammengeschaltet werden. Diese Batterien werden heutzutage insbesondere als Traktionsbatterien in Kraftfahrzeugen, beispielsweise in Elektro- oder Hybridfahrzeugen, zum Antreiben der Kraftfahrzeuge eingesetzt. Beim Einsatz der Batterien in Kraftfahrzeugen müssen diese jedoch gewisse Anforderungen erfüllen. Da die Traktionsbatterien einige hundert Volt bereitstellen können, müssen besondere Sicherheitsmaßnahmen getroffen werden, um beispielsweise eine Gefährdung von Personen zu vermeiden. Außerdem muss eine hohe Verfügbarkeit der Batterie gewährleistet werden. Diese Verfügbarkeit ist insbesondere abhängig von einem Schädigungsgrad beziehungsweise einer Alterung der Batterie. Da die Batteriezellen fertigungsbedingt Schwankungen in ihrer Kapazität sowie in ihrem Innenwiderstand aufweisen, werden sie in der Regel unterschiedlich schnell geladen und entladen. Dabei kann es zu einer Schädigung der Batterie kommen, wenn einzelne Zellen beispielsweise tiefenentladen oder überladen werden.

Um eine Batterie oder einzelne Batteriezellen zu überwachen, sind aus dem Stand der Technik Maßnahmen bekannt. So zeigt die DE 10 2010 011 740 A1 eine Batterie, bei welcher ein Zustand einzelner Batteriezellen von Sensoren erfasst und drahtlos an eine übergeordnete Zentraleinheit versendet wird. In der WO 2012/034045 A1 ist ein Batterieüberwachungssystem beschrieben, bei welchem eine Messeinrichtung an oder in einer Batteriezelle angebracht wird. Auch die WO 2004/047215 A1 offenbart ein Batteriemanagementsystem, bei welchem zur Verlängerung der Lebensdauer der Batterie physikalische Eigenschaften derselben überwacht werden.

Die WO 2013/143755 A1 offenbart eine Sensorvorrichtung für eine Batteriezelle eines elektrischen Energiespeichers. Die Batteriezelle weist ein Gehäuse auf, wobei die Sensorvorrichtung eine Erfassungseinrichtung zum Erfassen von Sensordaten aufweist, welche innerhalb des Gehäuses anordenbar ist auf. Ferner weist die Sensorvorrichtung eine Auswerteeinrichtung zum Auswerten der Sensordaten auf, welche innerhalb und außerhalb des Gehäuses anordenbar ist.

Die US 2014/0184165 A1 offenbart eine Sekundärbatterie umfassend einen Sensor, der eine Messeinheit ist, eine Mikrocontroller-Einheit, die eine Bestimmungseinheit ist, und einen Speicher, der eine Speichereinheit ist. Mit dem Sensor werden die Zustände der Sekundärbatterie, wie die verbleibende Batterieleistung, die Spannung, der Strom und die Temperatur gemessen. Die Mikrocontroller-Einheit führt eine arithmetische Verarbeitung der Messergebnisse durch und bestimmt den Betriebszustand der Sekundärbatterie. Außerdem speichert die Mikrocontroller-Einheit das Messergebnis im Speicher entsprechend dem Betriebszustand der Sekundärbatterie.
Da in Kraftfahrzeugen jedoch nur ein begrenzter Bauraum verfügbar ist, ist eine Integration der Batterien sowie deren Elektronik in dem Kraftfahrzeug eine große Herausforderung.

Es ist Aufgabe der vorliegenden Erfindung, mikroelektronische Schaltungen zur Überwachung einer Batteriezelle möglichst platzsparend zu integrieren, um einen Platzbedarf der Batteriezelle zu minimieren.

Diese Aufgabe wird erfindungsgemäß durch eine Batteriezelle, eine Batterie sowie ein Kraftfahrzeug mit den Merkmalen gemäß den unabhängigen Patentansprüchen gelöst. Vorteilhafte Ausführungen der Erfindung sind Gegenstand der abhängigen Patentansprüche, der Beschreibung und der Figuren.

Die erfindungsgemäße Batteriezelle für eine Batterie eines Kraftfahrzeugs umfasst ein galvanisches Element, ein Batteriezellengehäuse zum Aufnehmen des galvanischen Elementes und zumindest zwei mikroelektronische Schaltungen zum Überwachen der Batteriezelle. Darüber hinaus ist eine erste der zumindest zwei mikroelektronischen Schaltungen auf einem ersten Träger aufgebracht und eine zweite der zumindest zwei mikroelektronischen Schaltungen auf einem separaten zweiten Träger. Dabei sind die beiden Träger übereinander angeordnet und bilden somit einen Stapel, sodass eine Oberseite des ersten Trägers einer Unterseite des zweiten Trägers zugewandt ist.

Es ist vorgesehen, dass der die beiden Träger umfassende Stapel mechanisch und/oder thermisch mit einer Innenseite einer Wand des Batteriezellengehäuses gekoppelt ist. Bei einem beispielsweise quaderförmigen Batteriezellengehäuse und einer darin angeordneten beispielsweise galvanischen Zelle bestehen üblicherweise Hohlräume zwischen der galvanischen Zelle und dem Batteriezellengehäuse. Diese Hohlräume können zum Aufnehmen des Stapels sinnvoll genutzt werden. Zum sicheren Anordnen des Stapels innerhalb des Batteriezellengehäuses wird der Stapel an der Innenwand des Batteriezellengehäuses befestigt. Bei einem aus einem thermisch leitfähigen Material, beispielsweise Aluminium, gefertigten Batteriezellengehäuse kann dadurch Abwärme, welche durch die mikroelektronischen Schaltungen üblicherweise im Betrieb produziert wird, an das Batteriezellengehäuse und schließlich an die Umgebung außerhalb des Batteriezellengehäuses abgeführt werden. Somit kann der Stapel in vorteilhafter Weise gekühlt werden.

Das galvanische Element ist insbesondere als eine Sekundärzelle ausgestaltet, welche zum Versorgen einer elektrischen Komponente entladbar und nach der Entladung wieder aufladbar ist. Das galvanische Element umfasst dabei in an sich bekannter Weise zwei Elektroden und einen Elektrolyt. Das galvanische Element ist in dem Batteriezellengehäuse angeordnet, welches beispielsweise aus Aluminium gefertigt ist. Dabei kann das galvanische Element gegenüber dem Batteriezellengehäuse elektrisch isoliert sein. Dazu kann beispielsweise ein isolierendes Material zwischen einer Innenseite einer Wand der Batteriezellengehäuses und dem galvanischen Element angeordnet sein. Zum Versorgen einer elektrischen Komponente mit einer von der Batteriezelle bereitgestellten elektrischen Spannung und/oder zum Verschalten der Batteriezelle mit einer anderen Batteriezelle weist das Batteriezellengehäuse dabei zwei insbesondere exponierte Batteriepole beziehungsweise Batterieanschlüsse auf, wobei jeweils ein Batteriepol mit jeweils einer Elektrode des galvanischen Elementes elektrisch verbunden ist.

Zum Überwachen der Batteriezelle weist die Batteriezelle die zumindest zwei mikroelektronischen Schaltungen auf. Die mit mikroelektronischen Schaltungen versehene Batteriezelle kann auch als intelligente Batteriezelle bezeichnet werden. Jede der mikroelektronischen Schaltungen kann dabei zumindest ein sogenanntes Ein-Chip-System beziehungsweise SoC (System-on-a-Chip) umfassen. Bei einem solchen Ein-Chip-System werden verschiedene Funktionen eines Systems, beispielsweise in Form einer integrierten Schaltung (IC- Integrated Circuit), auf einem gemeinsamen Chip beziehungsweise Halbleitersubstrat integriert beziehungsweise vereint beziehungsweise programmiert. Das System beziehungsweise die integrierte Schaltung kann verschiedene Elemente beziehungsweise Komponenten, beispielsweise Halbleiterbauelemente, logische Schaltungen, Taktgeber, aktive und passiven Bauelemente, Sensoren oder FPGAs (Field Programmable Gate Arrays), umfassen, welche zusammengeschaltet eine bestimmte Funktionalität bereitstellen. Dabei können mehrere integrierte Schaltungen beziehungsweise Ein-Chip-Systeme über Leiterbahnen der mikroelektronischen Schaltung elektrisch miteinander verbunden sein.

Erfindungsgemäß ist nun jede der mikroelektronischen Schaltungen auf einem separaten Träger angeordnet. Die Träger können beispielsweise als Leiterplatten ausgeführt sein. Die Leiterplatten können dabei sowohl einseitig als auch beidseitig mit den Chips und den Leiterbahnen der jeweiligen mikroelektronischen Schaltung bestückt sein. Beispielsweise können die Leiterplatten als flexible Leiterplatten, sogenannte PCB-Folien (PCB printed circuit board) ausgestaltet sein. PCB-Folien weisen ein besonders geringes Gewicht und eine besonders geringe Dicke bei gleichzeitig hoher mechanischer Biegebelastbarkeit sowie hoher Temperaturbelastbarkeit auf. Es kann aber auch vorgesehen sein, dass die Leiterplatten als sogenannte Spritzgegossene Schaltungsträger beziehungsweise MID (Molded Interconnect Devices ausgestaltet sind. Solche Träger sind üblicherweise spritzgegossene Kunststoffbauteile, auch welche nach speziellen Verfahren metallische Leiterbahnen aufgebracht werden. Dabei können die Kunststoffbauteile insbesondere als dreidimensionale oder plastische Bauteile ausgestaltet. Ein als MID ausgeführter Träger ist somit besonders flexibel.

Diese separaten Träger sind übereinander gestapelt, sodass ein geschichteter Aufbau gebildet ist. Dabei ist der erste Träger unter dem zweiten Träger angeordnet, sodass die Oberseite des ersten Trägers der Unterseite des zweiten Trägers zugewandt ist. Dabei überlappen sich die Oberseite des ersten Trägers und die Unterseite des zweiten Trägers zumindest bereichsweise. Durch diesen geschichteten Aufbau können die Träger und mit diesen die mikroelektronischen Schaltungen besonders platzsparend in der Batteriezelle angeordnet werden. Außerdem können die Chips auf beiden Leiterplatten über besonders kurze Leitungswege elektrisch kontaktiert werden. In vorteilhafter Weise können die mikroelektronischen Schaltungen von dem galvanischen Element selbst mit elektrischer Energie versorgt werden. Somit wird ein autarkes System gebildet.

Gemäß einer Ausführungsform der Erfindung ist die erste mikroelektronische Schaltung in einem ersten Gehäuse angeordnet ist und die zweite mikroelektronische Schaltung in einem zweiten Gehäuse angeordnet. Die beiden gehäusten beziehungsweise eingehausten mikroelektronischen Schaltungen sind dabei auf dem jeweiligen Träger aufgebracht, wobei die beiden Träger elektrisch und/oder mechanisch miteinander gekoppelt sind.

Ein Träger mit einer elektronischen Schaltung, welche in einem Gehäuse angeordnet ist, wird auch als Package bezeichnet. Der durch das übereinander Anordnen von zwei oder mehr Packages entstehende Stapel wird auch als Package-on-Package (PoP) bezeichnet.

Dabei können die Packages, also die Träger mit den sich darauf befindlichen gehäusten mikroelektronischen Schaltungen, separat und unabhängig voneinander gefertigt werden. So kann die Fertigung der Packages beispielsweise auf verschiedene Hersteller mit deren jeweiligen Expertisen übertragen werden. Die einzelnen Packages können dann besonders flexibel und anforderungsspezifisch zum dem Stapel, also dem Package-on-Package, zusammengefügt werden. Mit anderen Worten bedeutet dies, dass eine Funktionalität des Stapels definiert und durch Zusammenfügen der entsprechenden Packages flexibel bereitgestellt werden kann. Zum elektrischen und mechanischen Verbinden können die Packages, insbesondere die Träger, zusammengelötet werden. Auch kann bei einem Defekt eines Packages oder eines Chips der mikroelektronischen Schaltung des Packages das entsprechende Package auf besonders einfache Weise ausgetauscht werden. Auch können durch die modulare Fertigung des Packages in vorteilhafter Weise die Packages einzeln getestet und bei einem Defekt gegebenenfalls ausgetauscht werden.

Gemäß einer weiteren Ausführungsform der Erfindung sind der erste Träger und der zweite Träger gemeinsam in einem Gehäuse angeordnet. Außerdem sind die beiden Träger innerhalb des gemeinsamen Gehäuses mechanisch und/oder elektrisch miteinander gekoppelt. Die Anordnung der Träger in einem gemeinsamen Gehäuse wird auch als System-in-Package (SiP) bezeichnet. Zur Versorgung der einzelnen mikroelektronischen Schaltungen und/oder zum Signalaustausch mit einer jeweils anderen mikroelektronischen Schaltung beziehungsweise mit einer Komponente außerhalb des Stapels können beispielsweise in einer Bodenfläche des gemeinsamen Gehäuses elektrische Kontaktflächen vorgesehen sein, welche beispielsweise über Bonddrähte mit den einzelnen Trägern elektrisch verbunden sind. Durch die Integration aller mikroelektronischen Schaltungen in einem Gehäuse kann der Stapel besonders platzsparend ausgeführt werden, und somit beispielsweise in einem besonders kleinen Hohlraum innerhalb des Batteriezellengehäuses angeordnet werden.

Es kann vorgesehen sein, dass das oder die Gehäuse aus einer gegenüber einem Elektrolyt des galvanischen Elementes unempfindlichen Material, insbesondere einer Keramik, gefertigt ist oder sind. Bei einer Anordnung des Stapels innerhalb der Batteriezelle dürfen die Gehäuse nicht durch den, beispielsweise flüssigen, Elektrolyt oder andere chemische Substanzen, aufgelöst werden oder korrodieren. Durch eine Korrosion kann sich beispielsweise die chemische Zusammensetzung des Elektrolyt und folglich ein Verhalten der Batteriezelle, insbesondere des galvanischen Elementes, verändern. Auch können bei einer Zerstörung des Gehäuses die chemischen Substanzen mit den mikroelektronischen Schaltungen in Berührung kommen und diese dadurch zerstören. Um dies zu verhindern, sind die Gehäuse bevorzugt aus Keramiken und/oder speziellen Kunststoffen oder dergleichen korrosionsbeständigen Materialen gefertigt. Somit kann ein Schutz der mikroelektronischen Schaltungen zuverlässige Weise bereitgestellt werden.

Besonders bevorzugt sind als die Elemente der mikroelektronischen Schaltung zumindest ein Sensorelement und/oder zumindest ein Speicherelement und/oder zumindest eine Kommunikationseinrichtung und/oder zumindest ein Mikroprozessor bereitgestellt. Das zumindest eine Sensorelement dient zum Erfassen einer physikalischen und/oder chemischen Eigenschaft der Batteriezelle. Eine solche physikalische und/oder chemische Eigenschaft kann beispielsweise eine Temperatur innerhalb des Batteriezellengehäuses, ein Druck innerhalb des Batteriezellengehäuses, eine Beschleunigung der Batteriezelle oder eine chemische Zusammensetzung des Elektrolyts des galvanischen Elementes sein.

Die von dem zumindest einen Sensorelement erfassten Daten können auf dem zumindest einen Speicherelement abgespeichert werden. Somit kann ein Zustand der Batteriezelle über eine gesamte Betriebsdauer beziehungsweise Lebensdauer der Batteriezelle überwacht werden. Der zumindest eine Mikroprozessor kann beispielsweise dazu ausgelegt sein, die von dem Sensorelement erfassten Daten und/oder die in dem Speicherelement abgespeicherten Daten auszuwerten, um beispielsweise eine Änderung einer physikalischen und/oder chemischen Eigenschaft über eine Betriebsdauer der Batteriezelle zu erfassen. Die zumindest eine Kommunikationseinrichtung kann beispielsweise dazu ausgelegt sein, mit Komponenten innerhalb und außerhalb der Batteriezelle zu kommunizieren. Eine Komponente außerhalb der Batteriezelle kann beispielsweise ein Batteriemanagementsystem des Kraftfahrzeugs oder eine andere Batteriezelle sein. Eine Komponente innerhalb der Zelle kann beispielsweise ein Element auf dem jeweils anderen Träger oder auch ein Sensor sein, welcher innerhalb des Batteriezellengehäuses an einem von dem Ort des Stapels unterschiedlichen Ort angeordnet ist. Die Kommunikationseinrichtung kann beispielsweise als eine Drahtlosübertragungseinrichtung ausgeführt sein, welche beispielsweise Daten über Bluetooth oder WLAN, aber auch beispielsweise über Ultraschall und Lichtwellen versendet und/oder empfängt.

Zur Erfindung gehört außerdem eine Batterie aufweisend eine Reihenschaltung und/oder Parallelschaltung von zumindest zwei erfindungsgemäßen Batteriezellen.

Ein erfindungsgemäßes Kraftfahrzeug umfasst zumindest eine erfindungsgemäße Batterie. Das Kraftfahrzeug kann beispielsweise als Personenkraftwagen, insbesondere als ein Elektro- oder Hybridkraftwagen ausgestaltet sein. Das Kraftfahrzeug kann aber auch als ein elektrisch betriebenes Motorrad oder Fahrrad ausgeführt sein.

Es ist aber auch möglich, die Batterie in einem stationären Energiespeichersystem vorzusehen. Dabei kann es beispielsweise vorgesehen sein, dass die Batterie, welche in einem Kraftfahrzeug bereitgestellt war, als sogenannte Second Life Batterie in dem stationären Energiespeichersystem weiterverwendet wird.

Die mit Bezug auf die erfindungsgemäße Batteriezelle vorgestellten bevorzugten Ausführungsformen und deren Vorteile gelten entsprechend für die erfindungsgemäße Batterie sowie das erfindungsgemäße Kraftfahrzeug.

Im Folgenden wird die Erfindung nun anhand eines bevorzugten Ausführungsbeispiels, wie auch unter Bezugnahme auf die beigefügten Zeichnungen näher erläutert.

Es zeigen:
- Fig. 1: eine schematische Darstellung einer Ausführungsform einer Batteriezelle, bei welcher mikroelektronischen Schaltungen auf verschiedenen Trägern angeordnet sind;
- Fig. 2: eine schematische Darstellung eines mit Bauelementen bestückten Substrates;
- Fig. 3: eine schematische Darstellung eines Stapels, welcher mikroelektronische Schaltungen aufweist; und
- Fig. 4: eine schematische Darstellung eines weiteren Stapels, welcher mikroelektronische Schaltungen aufweist.

In den Figuren sind gleiche und funktionsgleiche Elemente mit den gleichen Bezugszeichen versehen.

Bei dem im Folgenden erläuterten Ausführungsbeispiel handelt es sich um bevorzugte Ausführungsformen der Erfindung. Bei den Ausführungsbeispielen stellen aber die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

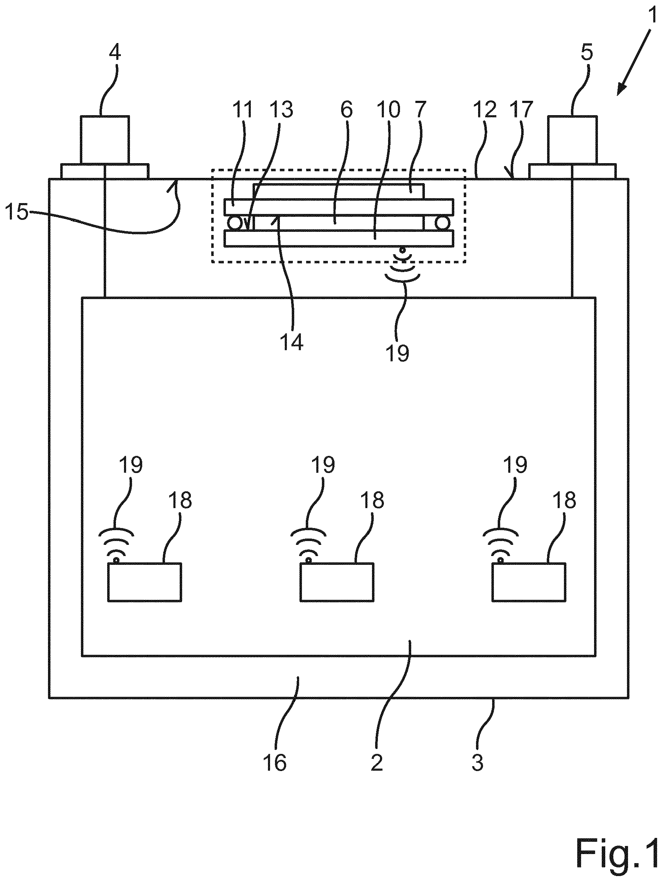

Fig. 1 zeigt eine Batteriezelle 1 mit einem galvanischen Element 2 sowie einem Batteriezellengehäuse 3. Dabei ist das galvanische Element 2 in dem Batteriezellengehäuse 3 angeordnet. Das Batteriezellengehäuse 3 kann beispielsweise aus Aluminium gefertigt sein. Das Batteriezellengehäuse 3 weist hier zwei exponierte beziehungsweise erhabene Anschlüsse 4 und 5 auf, über welche elektrische Energie, beispielsweise zum Versorgen einer elektrischen Komponente, abgreifbar ist und über welche der Batteriezelle 1 elektrische Energie zum Laden der Batteriezelle 1 zugeführt werden kann oder über welche die Batteriezelle 1 mit anderen gleichartigen Batteriezellen zu einer Batterie zusammenschaltbar ist. Eine solche Batterie kann beispielsweise in einem hier nicht gezeigten Kraftfahrzeug zum Antreiben des Kraftfahrzeugs angeordnet werden. Eine solche Batterie kann aber auch in einem hier nicht gezeigten stationären Energieversorgungssystem vorgesehen sein.

Die Batteriezelle 1 weist eine erste mikroelektronische Schaltung 6 und eine zweite mikroelektronische Schaltung 7 auf. Die mikroelektronischen Schaltungen 6 und 7 dienen zum Überwachen der Batteriezelle 1. Die mit den mikroelektronischen Schaltungen 6 und 7 versehene Batteriezelle 1wird als eine intelligente Batteriezelle 1 bezeichnet.

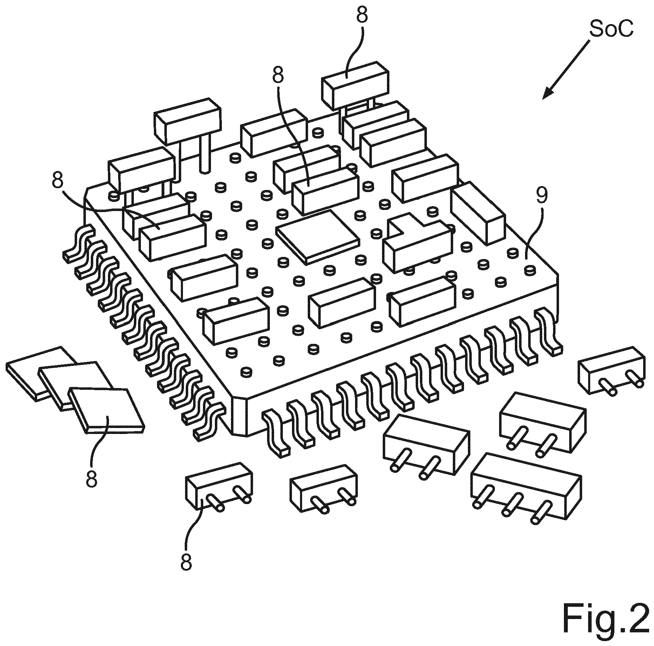

Jede der mikroelektronischen Schaltungen 6 und 7 kann dabei zumindest ein sogenanntes Ein-Chip-System beziehungsweise System-on-a-Chip SoC umfassen, welches in Fig. 2 dargestellt ist. Bei dem Ein-Chip-System SoC sind verschiedene Elemente 8 auf einem Chip 9 beziehungsweise einem Halbleitersubstrat angeordnet und stellen zusammengeschaltet eine bestimmte Funktionalität bereit. Die Elemente 8 können beispielsweise Halbleiterbauelemente, Sensoren, Speicherelemente, logische Schaltungen, Mikroprozessoren oder Kommunikationseinrichtungen sein. Dabei können mehrere solcher Ein-Chip-Systeme SoC beispielsweise über elektrische Leiterbahnen miteinander zu einer mikroelektronischen Schaltung verbunden sein.

Die erste mikroelektronische Schaltung 6 ist auf einem ersten Träger 10 und die zweite mikroelektronische Schaltung auf einem zweiten Träger 11 angeordnet. Die mit den mikroelektronischen Schaltungen 6 und 7 bestückten Träger 10 und 11 sind übereinander angeordnet und bilden einen Stapel 12, bei welchem eine Oberseite 13 des ersten Trägers 10 einer Unterseite 14 des zweiten Trägers 11 zugewandt ist.
Hier ist der Stapel 12 innerhalb des Batteriezellengehäuses 3 in einem Hohlraum 16 angeordnet, welcher zwischen einer Innenseite 15 einer Wand des Batteriezellengehäuses 3 und dem galvanischen Element 2 ausgebildet ist. Außerdem ist der Stapel 12 mit der Innenseite 15 des Batteriezellengehäuses 3 thermisch gekoppelt. Somit kann Abwärme, welche von den mikroelektronischen Schaltungen 6 und 7 im Betrieb produziert wird, an das Batteriezellengehäuse 3 und schließlich an die Umgebung der Batteriezelle 1 abgeführt werden.

Innerhalb des Batteriezellengehäuses 3 können weitere Komponenten 18, beispielsweise Temperatursensoren und/oder Drucksensoren, vorgesehen sein, welche über eine Drahtlosverbindung 19 mit der ersten mikroelektronischen Schaltung 6 und/oder der zweiten mikroelektronischen Schaltung 7 kommunizieren. Darüber hinaus kann über eine solche Drahtlosverbindung 19 auch Energie transferiert werden. Dazu kann beispielsweise ein hier nicht dargestellter Transformator vorgesehen sein, durch welchen Energie in Form von magnetischen Wellen übertragen wird.
Auch können die Komponenten 18 und/oder die Elemente 8 der mikroelektronischen Schaltungen 6 und 7 als sogenannte Low-Power-Komponenten oder als sogenannte Ultra-Low-Power-Komponenten ausgestaltet sein und somit einen geringen Energieverbrauch aufweisen. Außerdem können die Komponenten 18 und/oder die Elemente 8 der mikroelektronischen Schaltungen 6 und 7 als sogenannte Nanogeneratoren ausgestaltet sein und somit Energie aus der Umgebung, beispielsweise aus einem Temperaturgradienten innerhalb des Batteriezellengehäuses 3, gewinnen.

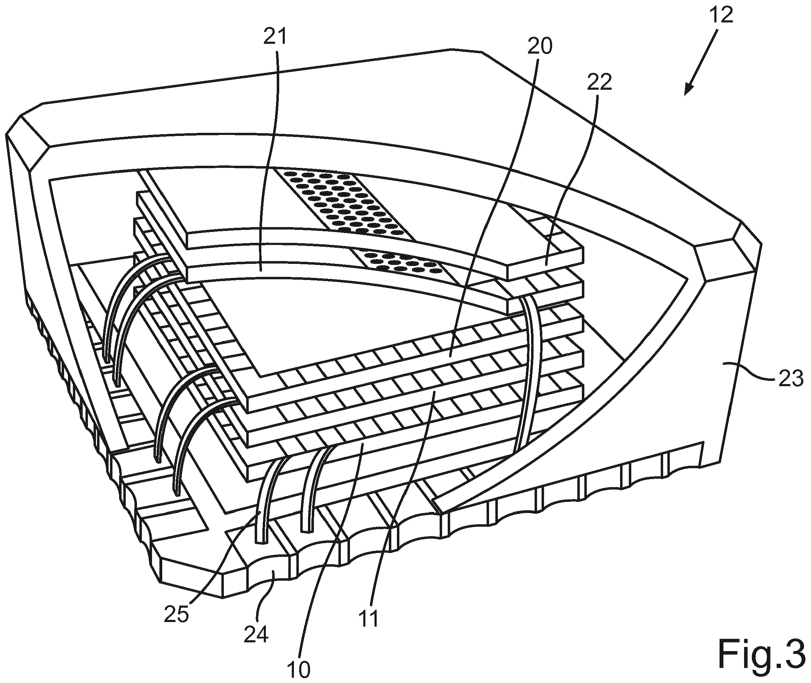

Fig. 3 zeigt eine schematische Darstellung des Stapels 12. Hier sind der erste Träger 10, der zweite Träger 11, ein dritter Träger 20, ein vierter Träger 21 und ein fünfter Träger 22 übereinander gestapelt. Die Träger 10, 11, 20, 21, 22 weisen jeweils eine mikroelektronische Schaltung auf und sind in einem gemeinsamen Gehäuse 23 angeordnet, welches hier bereichsweise geöffnet dargestellt ist. Das gemeinsame Gehäuse 23 weist mehrere elektrische Kontaktflächen 24 auf, welche über Bondverbindungen 25 mit den Trägern 10, 11, 20, 21, 22, insbesondere deren mikroelektronischen Schaltungen, elektrisch verbunden sind. Der Stapel 12, bei welchem die Träger 10, 11, 20, 21, 22 mit ihren mikroelektronischen Schaltungen in dem gemeinsamen Gehäuse 23 angeordnet sind, wird auch als System-in-Package (SiP) bezeichnet.

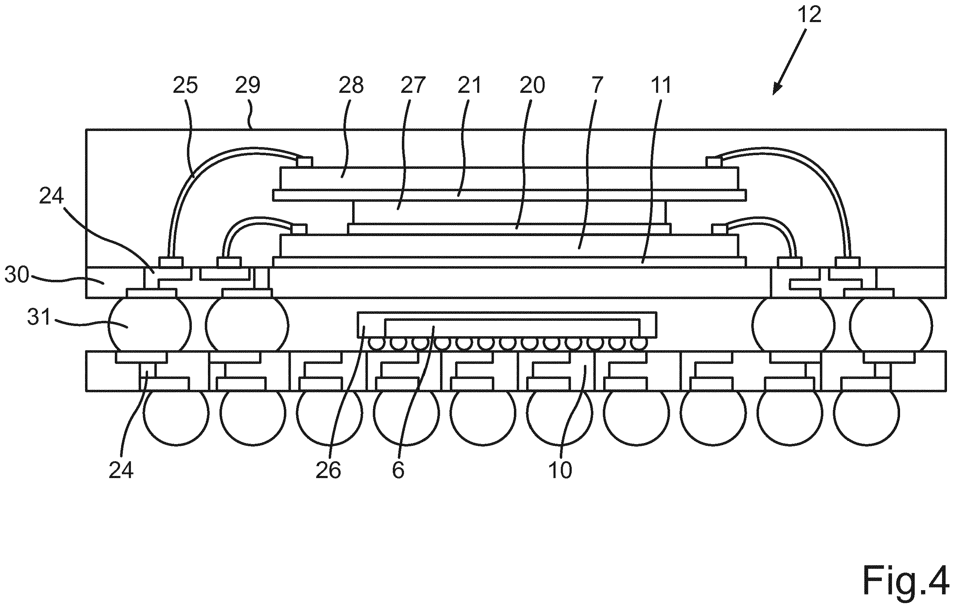

Fig. 4 zeigt einen weiteren Stapel 12 in einer Schnittansicht. Dabei ist die erste mikroelektronische Schaltung 6 in einem ersten Gehäuse 26 angeordnet. Das erste Gehäuse 26 ist auf dem ersten Träger 10 angeordnet. Das erste Gehäuse 26 mit der ersten mikroelektronischen Schaltung 6 und der erste Träger 10 bilden ein sogenanntes erstes Package. Der zweite Träger 11 mit der zweiten mikroelektronischen Schaltung 7, der dritte Träger 20 mit einer dritten mikroelektronischen Schaltung 27 und der vierte Träger 21 mit einer vierten mikroelektronischen Schaltung 28 sind in einem zweiten Gehäuse 29 angeordnet und bilden somit ein zweites Package. Die mikroelektronischen Schaltungen 7, 27, 28 sind über Lötverbindungen mit elektrischen Kontaktflächen 24 eines Gehäusebodens 30 des zweiten Gehäuses 29 elektrisch verbunden Das zweite Package hier als ein System-in-Package (SiP) ausgeführt, wie es beispielhaft in Fig. 3 gezeigt ist.

Das erste und das zweite Package sind mechanisch und elektrisch miteinander gekoppelt, indem die elektrischen Kontaktflächen 24 des Gehäusebodens 30 über ein elektrisch leitfähiges Verbindungselement 31, beispielsweise eine Lötverbindung, mit elektrischen Kontaktflächen 24 des ersten Trägers 10 verbunden sind. Die aufeinander gestapelten, miteinander kontaktierten Packages bilden ein sogenanntes Package-on-Package.

Das erste, untere Package wird dabei als Bottom-Package bezeichnet. Das Bottom-Package kann beispielsweise als die erste mikroelektronische Schaltung 6 eine logische Schaltung umfassen. Das auf dem Bottom-Package sitzende, aufkontaktierte zweite Package wird als Top-Package bezeichnet. Das Top-Package kann beispielsweise ein Speicherelement beziehungsweise einen Speicherbaustein umfassen. Das Package-on-Package kann auch mehr als zwei Packages umfassen.

Durch das Stapeln der Packages ergibt sich der Vorteil, dass die einzelnen mikroelektronischen Schaltungen 6, 7, 27, 28 separat getestet werden können. Wenn beispielsweise ein Chip SoC einer der mikroelektronischen Schaltungen 6, 7, 27, 28 defekt ist, kann dieser defekte Chip SoC oder das Package mit dem defekten Chip SoC auf einfache Weise ausgetauscht werden. Des Weiteren ist bis kurz vor der Kontaktierung der einzelnen Packages, also bis kurz vor dem Lötprozess, eine Festlegung einer bestimmten Chip-Kombination beziehungsweise einer bestimmten Package-Kombination möglich. So kann bei Package-on-Package beispielsweise der oben liegende Speicherchip, also das obere Package, welches den Speicherbaustein umfasst, vor dem Lötprozess in der Speichergröße variiert werden. Ein weiterer Vorteil des Stapels 12 gemäß Fig. 4 besteht in den kurzen Kontaktierungswegen zwischen den zwei Packages. Damit können beispielsweise der Speicher und die Verbindung zwischen zwei Chips mit hohen Taktfrequenzen betrieben werden.

Weil die Stapel 12, wie sie in den Fig. 3 und 4 gezeigt sind, innerhalb des Batteriezellengehäuses 3 angeordnet sind, sind die Gehäuse 23, 26, 29 bevorzugt aus einem korrosionsbeständigen Material gefertigt, welches durch das Elektrolyt des galvanischen Elementes 2 nicht beschädigt oder zerstört wird.

## Patentansprüche

1. Batteriezelle (1) für eine Batterie eines Kraftfahrzeugs mit einem galvanischen Element (2), einem Batteriezellengehäuse (3) zum Aufnehmen des galvanischen Elementes (2) und zumindest zwei mikroelektronischen Schaltungen (6, 7, 27, 28) zum Überwachen der Batteriezelle (1),
wobei
eine erste mikroelektronische Schaltung (6) der zumindest zwei mikroelektronischen Schaltungen (6, 7, 27, 28) auf einem ersten Träger (10) aufgebracht ist,
wobei eine zweite mikroelektronische Schaltung (7) der zumindest zwei mikroelektronischen Schaltungen (6, 7, 27, 28) auf einem separaten zweiten Träger (11) aufgebracht ist, wobei die beiden Träger (10, 11) übereinander angeordnet sind und somit einen Stapel (12) bilden, sodass eine Oberseite (12) des ersten Trägers (10) einer Unterseite (14) des zweiten Trägers (11) zugewandt ist, **dadurch gekennzeichnet, dass** der die beiden Träger (10, 11) umfassende Stapel (12) mechanisch und/oder thermisch mit einer Innenseite (15) einer Wand des Batteriezellengehäuses (3) gekoppelt ist.

2. Batteriezelle (1) nach Anspruch 1,
**dadurch gekennzeichnet, dass**
die erste mikroelektronische Schaltung (6) in einem ersten Gehäuse (26) angeordnet ist und die zweite mikroelektronische Schaltung (7) in einem zweiten Gehäuse (29) angeordnet ist und die beiden Träger (10, 11) mechanisch und/oder elektrisch miteinander gekoppelt sind.

3. Batteriezelle (1) nach Anspruch 1 oder 2,
**dadurch gekennzeichnet, dass**
der erste Träger (10) mit der ersten mikroelektronischen Schaltung (6) und der zweite Träger (11) mit der zweiten mikroelektronischen Schaltung (7) gemeinsam in einem Gehäuse (23) angeordnet sind und die beiden Träger (10, 11) mechanisch und/oder elektrisch miteinander gekoppelt sind

4. Batteriezelle (1) nach einem der Ansprüche 2 oder 3,
**dadurch gekennzeichnet, dass**
das oder die Gehäuse (23, 26, 29) aus einer gegenüber einem Elektrolyt des galvanischen Elementes (2) unempfindlichen Material, insbesondere einer Keramik, gefertigt ist oder sind.

5. Batteriezelle (1) nach einem der Ansprüche 1 bis 4,
**dadurch gekennzeichnet, dass**
die erste mikroelektronische Schaltung (6) und die zweite mikroelektronische Schaltung (7) zumindest eine der folgenden Komponenten (8) aufweist: zumindest einen Speicherbaustein, zumindest ein Sensorelement, zumindest eine Kommunikationseinrichtung, zumindest einen Mikroprozessor.

6. Batterie aufweisend eine Reihenschaltung und/oder Parallelschaltung von zumindest zwei Batteriezellen (1) nach einem der Ansprüche 1 bis 5.

7. Kraftfahrzeug mit zumindest einer Batterie nach Anspruch 6.

## Claims

1. Battery cell (1) for a battery of a motor vehicle having a galvanic element (2), a battery cell housing (3) for accommodating the galvanic element (2), and at least two microelectronic circuits (6, 7, 27, 28) for monitoring the battery cell (1), wherein
a first microelectronic circuit (6) of the at least two microelectronic circuits (6, 7, 27, 28) is attached to a first carrier (10),
wherein a second microelectronic circuit (7) of the at least two microelectronic circuits (6, 7, 27, 28) is attached to a separate second carrier (11), wherein the two carriers (10, 11) are arranged on top of one another and thus form a stack (12), so that a top side (12) of the first carrier (10) is facing toward a bottom side (14) of the second carrier (11),
**characterised in that** the stack (12) comprising the two carriers (10, 11) is coupled mechanically and/or thermally to an inside (15) of a wall of the battery cell housing (3).

2. Battery cell (1) according to claim 1,
**characterised in that**
the first microelectronic circuit (6) is arranged in a first housing (26) and the second microelectronic circuit (7) is arranged in a second housing (29), and the two carriers (10, 11) are mechanically and/or electrically coupled to one another.

3. Battery cell (1) according to claim 1 or 2,
**characterised in that**
the first carrier (10) with the first microelectronic circuit (6) and the second carrier (11) with the second microelectronic circuit (7) are arranged together in one housing (23), and the two carriers (10, 11) are mechanically and/or electrically coupled to one another.

4. Battery cell (1) according to any of claims 2 or 3,
**characterised in that**
the housing or housings (23, 26, 29) is or are produced from a material that is not sensitive to an electrolyte of the galvanic element (2), in particular a ceramic material.

5. Battery cell (1) according to any of claims 1 to 4,
**characterised in that**
the first microelectronic circuit (6) and the second microelectronic circuit (7) has at least one of the following components (8): at least one storage module, at least one sensor element, at least one communication device, at least one microprocessor.

6. Battery cell having a series circuit and/or parallel circuit of at least two battery cells (1) according to any of claims 1 to 5.

7. Motor vehicle having at least one battery according to claim 6.

## Revendications

1. Elément de batterie (1) pour une batterie d'un véhicule à moteur avec un élément galvanique (2), un boîtier d'élément de batterie (3) permettant de recevoir l'élément galvanique (2) et au moins deux circuits microélectroniques (6, 7, 27, 28) permettant de surveiller l'élément de batterie (1),
dans lequel
un premier circuit microélectronique (6) des au moins deux circuits microélectroniques (6, 7, 27, 28) est appliqué sur un premier support (10),
dans lequel
un second circuit microélectronique (7) des au moins deux circuits microélectroniques (6, 7, 27, 28) est appliqué sur un second support (11) séparé, dans lequel les deux supports (10, 11) sont disposés l'un au-dessus de l'autre et forment donc une pile (12), de sorte qu'une face supérieure (12) du premier support (10) est tournée vers une face inférieure (14) du second support (11), **caractérisé en ce que** la pile (12) comprenant les deux supports (10, 11) est accouplée mécaniquement et/ou thermiquement à une face intérieure (15) d'une paroi du boîtier d'élément de batterie (3).

2. Elément de batterie (1) selon la revendication 1,
**caractérisé en ce que**
le premier circuit microélectronique (6) est disposé dans un premier boîtier (26) et le second circuit microélectronique (7) est disposé dans un second boîtier (29) et les deux supports (10, 11) sont accouplés mécaniquement et/ou électriquement l'un à l'autre.

3. Elément de batterie (1) selon la revendication 1 ou 2,
**caractérisé en ce que**
le premier support (10) avec le premier circuit microélectronique (6) et le second support (11) avec le second circuit microélectronique (7) sont disposés conjointement dans un boîtier (23) et les deux supports (10, 11) sont accouplés mécaniquement et/ou électriquement l'un à l'autre.

4. Elément de batterie (1) selon l'une quelconque des revendications 2 ou 3,
**caractérisé en ce que**
le ou les boîtiers (23, 26, 29) est ou sont fabriqués à partir d'un matériau insensible à un électrolyte de l'élément galvanique (2), en particulier d'une céramique.

5. Elément de batterie (1) selon l'une quelconque des revendications 1 à 4,
**caractérisé en ce que**
le premier circuit microélectronique (6) et le second circuit microélectronique (7) présente au moins un des composants (8) suivants : au moins un module de mémoire, au moins un élément capteur, au moins un dispositif de communication, au moins un microprocesseur.

6. Batterie présentant un montage en série et/ou montage en parallèle d'au moins deux éléments de batterie (1) selon l'une quelconque des revendications 1 à 5.

7. Véhicule à moteur avec au moins une batterie selon la revendication 6.
